# EUROPEAN PATENT APPLICATION

(11) **EP 4 130 552 A1**
(43) Date of publication of application: **08.02.2023**
(21) Application number: 22154125.3
(22) Date of filing: 30.01.2022
(51) Int. Cl.: F21S 4/24, F21V 21/002, F21V 19/00, F21Y 115/10

(54) **LED LAMP MODULE**

(30) Priority: 04.08.2021 CN 202110894188; 18.09.2021 CN 202111104660
(71) Applicant: Chongyi Jingyi Lighting Products Co., Ltd., Ganzhou City, Jiangxi 341000 (CN)
(72) Inventor: He, Yaoquan, Ganzhou City (CN)
(74) Representative: Huang, Liwei

(57) **Abstract**

Disclosed is an LED lamp module (100). A first electrode wire (115) continuously runs through two sides of a first LED illuminator (120), and the first electrode wire (115) is connected to a first conductive pin of the first LED illuminator (120). A second electrode wire (116) continuously runs through the two sides of the first LED illuminator (120), and the second electrode wire (116) is connected to a second conductive pin of the first LED illuminator (120). After the flexible insulating layers of the first electrode wire (115) and the second electrode (116) wire are previously removed, the corresponding conductive pin is connected to the corresponding electrode wire. Among two ends of the first electrode wire and two ends of the second electrode wire, at least 2 terminals on the same sides of the first electrode wire and the second electrode wire are left and used for front and back cascade connection to modules of the same structure or for connection to a power source.

## Description

### TECHNICAL FIELD

The invention relates to decorative lamps, in particular to an LED lamp module.

### BACKGROUND

Decorative lamps include illuminating lamps exposed outdoors, which can usually be subjected to lighting design and installed in combination with the surrounding roads, landscapes, trees, green plants and buildings, so as to achieve both the illuminating function and artistry.

At present, the existing decorative lamp is mainly composed of a power cord with a certain length and a plurality of lamp holders disposed on the power cord and electrically connected to the power cord. The lamp holders are disposed on the power cord at intervals. When this high-voltage outdoor lamp is in specific use, a bulb may be connected and installed to each of the lamp holders, and the power cord may be suspended in a place where illumination is required, so that the use effects of large-area surrounding illumination and decoration can be achieved.

However, the decorative lamp of this structure mainly has the following two problems. First, it is required to connect each section of power cord to the corresponding lamp holder and connect the sections of power cord sequentially to form the multi-section power cord with a certain length and the plurality of lamp holders thereof, so the manufacturing process is complex. Second, the decorative lamp is easily damaged during use, so the service life is short.

### SUMMARY

In view of this, the invention provides an LED lamp module, including:
a first LED illuminator,
a first electrode wire covered with a first flexible insulating layer, and
a second electrode wire covered with a second flexible insulating layer,
wherein,
two sides of the first LED illuminator at least include: a first wire pin corresponding to the first electrode wire and a second wire pin corresponding to the second electrode wire;
the first electrode wire continuously runs through the two sides of the first LED illuminator, and the first electrode wire is connected to a first conductive pin of the first LED illuminator; wherein the position connected to the first conductive pin is a first conductive point of the first electrode wire;
the second electrode wire continuously runs through the two sides of the first LED illuminator, and the second electrode wire is connected to a second conductive pin of the first LED illuminator; wherein the position connected to the second conductive pin is a second conductive point of the second electrode wire;
the first and second conductive points are connected to the first and second conductive pins after the flexible insulating layers of the first electrode wire and the second electrode wire are previously removed; and
among two ends of the first electrode wire and two ends of the second electrode wire, at least 2 terminals on the same sides of the first electrode wire and the second electrode wire are left and used for front and back connection to modules of the same structure or for connection to a power source.

Preferably,
the first and second conductive pins, the first and second conductive points and the first LED illuminator are all packaged in a package having certain light transmittance.

Preferably,
the flexible insulating layer is made of a rubber material or a PVC material.

Preferably,
the first electrode wire and the second electrode wire are connected via a first connecting portion with insulation characteristics.

Preferably,
the first electrode wire and the second electrode wire are jointly covered by a third insulating layer.

Preferably,
the first and second conductive points are formed by cutting the first and second electrode wires by a combined blade.

Preferably,
when the connected power source is of an AC type, the first LED illuminator further includes an AC/DC unit; and
when the connected power source is of a DC or AC type, the first LED illuminator further includes a current limiting IC.

Preferably,
the package at least has any one of the following characteristics:
(1) the outside of the package is sleeved with a casing model with a shape, or the outside of the package is modeled by injection molding;
(2) the package is packaged by glue; and
(3) the package has a substantially spherical structure.

Preferably,
the module at least has any one of the following characteristics:
(1) the first electrode wire further continuously runs through two sides of a second LED illuminator, and the first electrode wire is connected to a fifth conductive pin of the second LED illuminator; wherein the position connected to the fifth conductive pin is a fifth conductive point of the first electrode wire;
   the first electrode wire further continuously runs through the two sides of the second LED illuminator, and the first electrode wire is connected to a sixth conductive pin of the second LED illuminator; wherein the position connected to the sixth conductive pin is a sixth conductive point of the first electrode wire;
   the first and second LED illuminators are cut apart to facilitate the free cutting and use of the module; and
(2) the inside of the first LED illuminator at least includes two LED chips connected in series to accurately control the current of the LED illuminator during voltage division.

The invention further provides an LED lamp, including:
an outside package structure having certain light transmittance; wherein
the outside package structure includes any one of the modules described above.

In summary, the invention is beneficial to the improvement of manufacturing efficiency: it is only required to prepare the first electrode wire and the second electrode wire that are long enough, previously remove the flexible insulating layer at the corresponding conductive point and connect the conductive point to the corresponding conductive pin of the LED illuminator, for example, by welding. Moreover, when the plurality of LED illuminators are connected in parallel, each of the LED illuminators can be cut off conveniently. After cutting, the LED illuminator can still work when connected to the original power supply voltage, and will not be burned out with the same high probability as a series product, so that the invention is beneficial to both flexible deployment and maintenance. The distance between the adjacent LED illuminators is controlled such that the flexible insulating layer can be removed at one time.

### BRIEF DESCRIPTION OF THE DRAWINGS

In order to more clearly illustrate the technical solutions of the examples of the invention, the drawings used in the examples will be briefly described below. It should be understood that the following drawings show only certain examples of the invention, and therefore, should not be considered as limiting the scope. Those skilled in the art can obtain other related drawings according to these drawings without any creative work.
Fig. 1 is a schematic structural diagram of an LED lamp module according to one example of the invention;
Fig. 2 is a schematic structural diagram of an LED illuminator in the LED lamp module from a first viewing angle according to one example of the invention;
Fig. 3 is a schematic structural diagram of the LED illuminator in the LED lamp module from a second viewing angle according to one example of the invention;
Fig. 4-1 to Fig. 4-3 are partial enlarged schematic diagrams of the LED lamp module according to one example of the invention;
Fig. 5 is a partial enlarged schematic diagram of the LED illuminator according to one example of the invention; and
Fig. 6-1 to Fig. 6-2 are schematic diagrams of an LED lamp module after packaging according to one example of the invention.

Reference numerals: 100-LED lamp module; 110-outdoor rubber cord; 111-rubber insulating layer; 112-first channel; 113-second channel; 114-connecting portion; 115-positive wire; 116-negative wire; 117-conductive point; 120-LED illuminator; 121-bracket; 122-first substrate; 123-second substrate; 124-first cup; 125-second cup; 126-light transmitting layer; 127-current limiting IC; 128-light emitting chip; 130-package; 140-model.

It should be noted that the above drawings do not limit the dimension scale between the wires and parts such as the LED illuminator, the chip and the like. The drawings are more indicative of the structure, connection relationship, spatial position relationship and the like.

### DETAILED DESCRIPTION

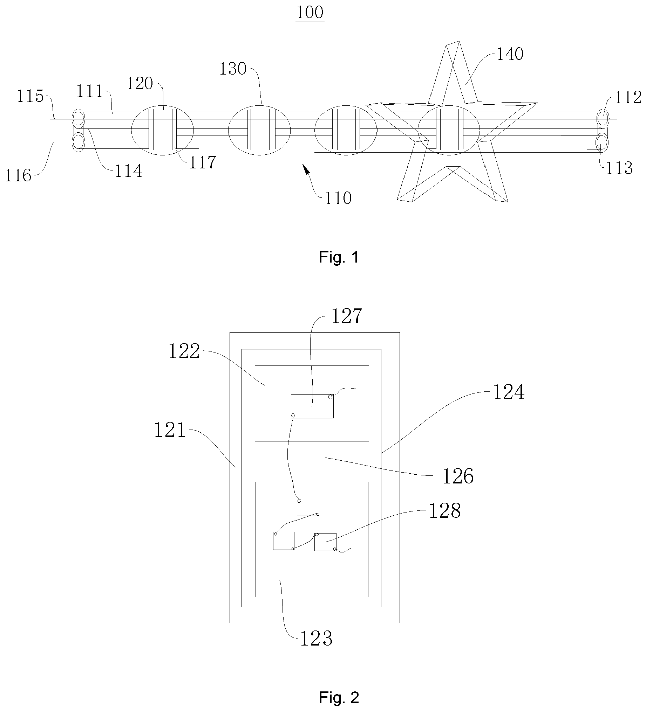

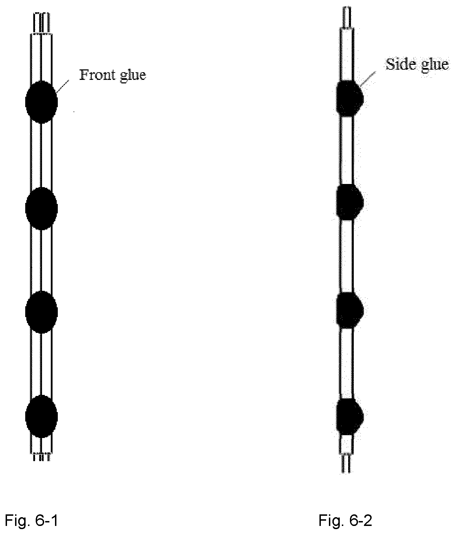

In order to make the objectives, technical solutions and advantages of the examples of the invention more clear, the technical solutions in the examples of the invention will be clearly and completely described below with reference to Fig. 1 to Fig. 6-2 in the examples of the invention. It is apparent that the described examples are a part of the examples of the invention, rather than all of the examples. The components of the examples of the invention, which are generally described and illustrated in the drawings herein, may be arranged and designed in various different configurations.

Therefore, the detailed description of the examples of the invention in the drawings is not intended to limit the protection scope of the invention, but merely represents the selected examples of the invention. All other examples obtained by those of ordinary skill in the art based on the examples in the invention without creative work are within the protection scope of the invention.

It should be noted that similar reference numerals and letters indicate similar items in the following drawings, and therefore, once an item is defined in a drawing, it is not necessary to further define and explain it in the subsequent drawings.

In the description of the invention, it should be noted that the orientation or position relationship indicated by the term "upper", "lower", "inner", "outer" or the like is the orientation or position relationship based on the drawings or the orientation or position relationship in which the product of the invention is usually placed when in use. It is only for the convenience of describing the invention and simplifying the description, rather than indicating or implying that the device or element referred to must have a specific orientation or be constructed and operated in a specific orientation, and therefore cannot be understood as a limitation to the invention.

In addition, the terms "first", "second" and the like are only used for descriptive purposes, and cannot be understood as indicating or implying relative importance.

It should be noted that in the case of no conflict, the features in the examples may be combined with each other.

In another example, the invention provides an LED lamp module, including:
a first LED illuminator,
a first electrode wire covered with a first flexible insulating layer, and
a second electrode wire covered with a second flexible insulating layer,
wherein
two sides of the first LED illuminator at least include: a first wire pin corresponding to the first electrode wire and a second wire pin corresponding to the second electrode wire;
the first electrode wire continuously runs through the two sides of the first LED illuminator, and the first electrode wire is connected to a first conductive pin of the first LED illuminator; wherein the position connected to the first conductive pin is a first conductive point of the first electrode wire;
the second electrode wire continuously runs through the two sides of the first LED illuminator, and the second electrode wire is connected to a second conductive pin of the first LED illuminator; wherein the position connected to the second conductive pin is a second conductive point of the second electrode wire;
the first and second conductive points are connected to the first and second conductive pins after the flexible insulating layers of the first electrode wire and the second electrode wire are previously removed; and
among two ends of the first electrode wire and two ends of the second electrode wire, at least 2 terminals on the same sides of the first electrode wire and the second electrode wire are left and used for front and back cascade connection to modules of the same structure or for connection to a power source.

For this example, the first and second electrode wires continuously run through the two sides of the first LED illuminator, and the first and second conductive points are connected to the first and second conductive pins after the flexible insulating layers are previously removed. Therefore, the first and second electrode wires in the above example can run throughout the first LED illuminator, and there is no need to respectively use two pre-cut electrode wires on the two sides of the first LED illuminator to be connected to the first LED illuminator. This is apparently beneficial to the improvement of manufacturing efficiency: it is only required to prepare the first electrode wire and the second electrode wire that are long enough, previously remove the flexible insulating layer at the corresponding conductive point and connect the conductive point to the corresponding conductive pin of the LED illuminator, for example, by welding.

In another example,
the first and second conductive pins, the first and second conductive points and the first LED illuminator are all packaged in a package having certain light transmittance.

It can be understood that this protects not only the relevant pins and conductive points, but also the LED illuminator, and also avoids the influence of light as much as possible. The having certain light transmittance typically includes following situations: being transparent, being translucent, having a certain hazy effect, etc.

In another example,
the flexible insulating layer is made of a rubber material or a PVC material.

It can be understood that the outdoor waterproof and anti-aging properties of the rubber material enable the module to be used in more severe outdoor environments. The PVC material may also be used as a selection of the flexible insulating layer.

In another example,
the flexible insulating layer may be an insulating layer in a double-layer structure.

In another example,
the first electrode wire and the second electrode wire are connected via a first connecting portion with insulation characteristics.

For this example, it means that the first electrode wire and the second electrode wire belong to rubber wires and there is a definite connection between the first electrode wire and the second electrode wire. This apparently can improve the overall protective performance of the module and make the module not easily torn off.

In another example, the first electrode wire and the second electrode wire are substantially parallel. It can be understood that this is beneficial to previously removing the flexible insulating layer at the corresponding conductive point and convenient for a cutting tool or a manipulator to locate each electrode wire.

In another example,
the first electrode wire and the second electrode wire are jointly covered by a third insulating layer.

For this example, it means that the wire may also be a wire covered by an external insulating layer. This may also improve the overall protective performance of the module and make the module not easily torn off.

In another example,
the first and second conductive points are formed by cutting the first and second electrode wires by a combined blade.

Typically, the first and second conductive points are formed by respectively cutting the original insulating layers somewhere on the first electrode wire and the second electrode wire by first and second blades in the combined blade. Optionally, the combined blade may be two blades. A locating device, for example, an optical or visual locating device, may also be used in combination to locate the cutting position, and the manipulator may be driven to drive the blade to the target position so as to cut the insulating layer. Furthermore, the manipulator may further peel away the insulating layer around the conductive point to facilitate the connection between the conductive pin of the LED illuminator and the conductive point.

It can be understood that for the invention, the LED lamp module may further include a third conductive pin and a corresponding third conductive point. Typically, for example, in one LED illuminator, two LED chips with a common positive electrode or a common negative electrode are involved. Similarly, the LED lamp module may further include a fourth conductive pin and a corresponding fourth conductive point. Taking four conductive points as an example, the combined blade may cut the corresponding insulating layers for several times at four different positions to form the first, second, third and fourth conductive points. Furthermore, in order to more accurately cut the electrode wires so as to remove the insulating layers and expose the conductive points, the optical or visual locating device combined with AI technology may be used to realize accurate locating and cut and peel the insulating layers.

In another example,
when the connected power source is of an AC type, the first LED illuminator further includes an AC/DC unit; and
when the connected power source is of a DC or AC type, the first LED illuminator further includes a current limiting IC.

It can be understood that when the AC/DC module is included, it is to drive the LED illuminator through DC. When the AC/DC module is not included, the LED illuminator may be driven directly by AC. According to the hertz of AC, human eyes generally cannot detect the blinking of the LEDs. When the current limiting IC is included, it means that the value of the current flowing through each LED illuminator can be limited.

It should be noted that when the first LED illuminator further includes the current limiting IC, this is of special significance for high-voltage power supply. This is because: when the front and back cascade connection of the LED illuminators is parallel cascade connection, each of the LED illuminators may have the same voltage, and the current and power of each of the LED illuminators are accurately controlled by limiting the current, so that the parallel connection is more advantageous than the series-connection high-voltage solution in the prior art that can only accurately control the current. That is, the invention can realize a better high-voltage low-power accurate-control LED illumination solution. Besides, this helps to realize a parallel LED illuminating product with a larger length. Especially in the case where the current is limited to be extremely small, as long as the LEDs can still satisfy the visual brightness, since the small current makes the power of each loop relatively low, on the premise of a definite total power, the parallel LED illuminating product with a larger length can be realized while the voltages of the parallel branches are equal. It can be understood that when AC power supply is used, the first and second electrode wires may be neutral and live wires. When the DC power supply is used, the first and second electrode wires may be positive and negative power supply wires.

In addition, it should be specially emphasized that the current limiting IC is more preferably a constant current IC. Exemplarily, the constant current IC provides 0.6-0.8 mA, and at 110V, the LED illuminator is made to work at a very low power and thus cannot be burned out. It can be understood that by configuring a certain number of LED chips, the product of the invention can work at a voltage such as 110V and cannot be burned out, and the parallel LED illumination can be extended long enough.

In another example,
the package at least has any one of the following characteristics:
(1) the outside of the package is sleeved with a casing model with a shape, or the outside of the package is modeled by injection molding;
(2) the package is packaged by glue; and
(3) the package has a substantially spherical structure.

In another example,
the module at least has any one of the following characteristics:
(1) the first electrode wire further continuously runs through two sides of a second LED illuminator, and the first electrode wire is connected to a fifth conductive pin of the second LED illuminator; wherein the position connected to the fifth conductive pin is a fifth conductive point of the first electrode wire;
   the first electrode wire further continuously runs through the two sides of the second LED illuminator, and the first electrode wire is connected to a sixth conductive pin of the second LED illuminator; wherein the position connected to the sixth conductive pin is a sixth conductive point of the first electrode wire;
   the first and second LED illuminators are cut apart to facilitate the free cutting and use of the module; and
(2) the inside of the first LED illuminator at least includes two LED chips connected in series to accurately control the current of the LED illuminator during voltage division.

It should be noted that when the module further includes the second LED illuminator connected in parallel, this is of special significance. This is because: when the plurality of LED illuminators are connected in parallel front and back, any one of the LED illuminators can be freely cut off to adapt to the length required in different scenarios. Even if one of the LED illuminators is faulty, the faulty LED illuminator can be freely cut off, and the electrode wires of the LED illuminators before and after the faulty LED illuminator can be directly connected, so the module is convenient for maintenance. The series connection of the plurality of LED chips inside the LED illuminator is to accurately control the current of the LED illuminator during voltage division.

In fact, the above examples of the invention prefer the solution of the parallel connection of a plurality of LED illuminators. In the case of the parallel connection, each of the LED illuminators can be freely cut off. After cutting, each of the LED illuminators can meet the requirement of power supply voltage when connected to a power source. Otherwise, no matter how large the length is and how many LED illuminators are connected in parallel, the requirement of power supply voltage should not be met at the beginning and each of the LED illuminators connected in parallel will be directly burned out. For example, in a scenario of using 110V-230V AC power supply, each of the LED illuminators itself includes tens of LED chips connected in series or in series and parallel inside to withstand an AC voltage of 110V or 230V. The LED module of the invention includes 3 LED illuminators. If any of the LED illuminators is cut off, on the premise of preserving the electrode wires on the two sides of the LED illuminator, when the LED illuminator is connected to 110V or 230V AC power, as long as the LED illuminator is not faulty, a loop can be formed such that the LED illuminator can emit light. In contrast, it is apparent that the LED illuminators connected in series cannot make it, because a plurality of LED illuminators connected in in series can work under a voltage of 110V or 230V only as a whole. If one of the LED illuminators is directly cut off and connected to the voltage of 110V or 230V, this LED illuminator will be burned out with a high probability. It can be understood that the voltage of the invention is not limited to 110V, 230V, etc., it can be other power supply voltage standards or a wider voltage range.

Therefore, in the case of parallel connection, each of the LED illuminators in the module can be freely cut off. After cutting, each of the LED illuminators can meet the requirement of power supply voltage when connected to a power source. In addition, in the case where an LED illuminator is faulty, the faulty LED illuminator can be freely cut off, and the original sections before and after the faulty LED illuminator can be connected, and continue to work under the same power supply voltage on the premise of little loss in length while maintaining the same visual effect of illumination, that is, brightness.

In another example, when the first LED illuminator includes first, second, third and fourth wire pins and the second LED illuminator includes fifth, sixth, seventh and eighth conductive pins:
along an extension direction of the first electrode wire, when continuously running through the second LED illuminator, the first electrode wire is also respectively connected to the fifth and seventh conductive pins of the second LED illuminator; wherein the position connected to the fifth conductive pin is a fifth conductive point of the first electrode wire, and the position connected to the seventh conductive pin is a seventh conductive point of the first electrode wire; along the extension direction of the second electrode wire, when continuously running through the second LED illuminator, the second electrode wire is also respectively connected to the sixth and eighth conductive pins of the LED illuminator; wherein the position connected to the sixth conductive pin is a sixth conductive point of the second electrode wire, and the position electrically connected to the eighth conductive pin is an eighth conductive point of the second electrode wire; and
the first and second LED illuminators can be cut apart to facilitate the free cutting and use of the module.

In another example, the LED illuminator is of an SMD type. This is more beneficial to improving the manufacturing efficiency and ensuring the product performance.

In another example, the LED illuminator is of a high-voltage type. This is beneficial to the manufacture of the high-voltage parallel product.

In another example, the invention further provides an LED lamp, including:
an outside package structure having certain light transmittance; wherein
the outside package structure includes any one of the modules described above.

It can be understood that this is to integrally package the LED lamp module of the invention as a package object into the outside package structure having certain light transmittance. When the LED lamp module of the invention can be made very small, such an LED lamp obviously has its significance.

Fig. 1 is a schematic structural diagram of an LED lamp module 100 according to this example. With reference to Fig. 1, this example provides an LED lamp module 100, including a power cord, a plurality of packages 130 and a plurality of LED illuminators 120. The plurality of LED illuminators 120 are disposed at intervals along an extension direction of the power cord, and the plurality of LED illuminators 120 are respectively fixed to conductors of the power cord by welding, so that the LED illuminators 120 are electrically connected to the conductors, thereby meeting the light emitting demand of the LED illuminators 120. Meanwhile, the plurality of packages 130 and the plurality of LED illuminators 120 are disposed in one-to-one correspondence, and the package 130 wraps the LED illuminator 120 and the conductive pins of the LED illuminator 120 to the conductor so as to protect the LED illuminator 120 and play a good waterproof role, thereby preventing the LED lamp module 100 from being damaged and helping to prolong the service life of the LED lamp module 100. The plurality of LED illuminators 120 are connected in parallel, and light emitting chips 128 in the LED illuminators 120 are high-voltage chips. Thus, the product formed by parallel connection of the plurality of LED illuminators 120 can be connected to a high voltage for use, thereby meeting the outdoor use demand. Moreover, the product formed by parallel connection can be freely cut according to demands, so the use effect is better.

The LED lamp module 100 provided by this example will be further described below: With continued reference to Fig. 1, in this example, the power cord is an outdoor rubber cord 110. The outdoor rubber cord 110 has the characteristics of aging resistance, good flexibility, good elasticity and the like, and helps to prolong the overall service life of the outdoor product. The conductors include a positive wire 115 and a negative wire 116. The outdoor rubber cord 110 further includes a rubber insulating layer 111. The rubber insulating layer 111 wraps the positive wire 115 and the negative wire 116, and the rubber insulating layer 111 has a conductive point 117, thereby exposing the positive wire 115 and the negative wire 116 at the conductive point 117. The LED illuminator 120 is disposed at the conductive point 117 to contact the positive wire 115 and the negative wire 116, so that the LED illuminator 120 is electrically connected to the positive wire 115 and the negative wire 116. The rubber insulating layer 111 is provided with a plurality of conductive points 117 at intervals, the plurality of LED illuminators 120 are disposed at the plurality of conductive points 117 in one-to-one correspondence, and each of the LED illuminators 120 is electrically connected to the positive wire 115 and the negative wire 116. The plurality of LED illuminators 120 are connected to each other in parallel in the LED lamp module 100 made in this way. When in use, the LED lamp module can be cut according to demands, and a required number of LED illuminators 120 are reserved. This avoids the problem that in a like product, for example, formed by series connection, cutting can only be done based on a specified unit or number of LED illuminators, because wrong cutting will cause this section of lamp to fail to be on.

Specifically, during production, a combined blade is used to cut the rubber insulating layer 111 of the outdoor rubber cord 110 to form the conductive point 117 where the positive wire 115 and the negative wire 116 are exposed. Then, the LED illuminator 120 is fixed to the positive wire 115 and the negative wire 116 at the conductive point 117 by welding, thereby realizing the electrical connection to the positive wire 115 and the negative wire 116. After welding is completed, the package 130 is wrapped around the conductive point 117, so that the LED illuminator 120 and the conductive point 117 are enclosed in the package 130, thereby achieving the waterproof and protective functions.

Optionally, after welding is completed, the package 130 is formed with glue at the conductive point 117. The package 130 has a spherical structure. The LED illuminator 120 is completely enclosed in the package 130, and the positive wire 115 and negative wire 116 exposed at the conductive point 117 are also wrapped by the package 130, and the glue can bond well to the outdoor rubber cord 110, thereby ensuring the waterproof effect and the protection for the LED illuminator 120. Further, in order to further ensure the appearance and effects, the package 130 may be sleeved with a casing model with other shapes. Or the outside of the package 130 may be modeled by injection molding. The model 140 shown in Fig. 1 is in a star shape. It can be understood that in other examples, the appearance of the model 140 may be specifically set according to demands, for example, in a heart shape, tree shape or the like.

Further, the rubber insulating layer 111 has a first channel 112 and a second channel 113 independent of each other therein. The positive wire 115 runs through the first channel 112, and the negative wire 116 runs through the second channel 113. The conductive point 117 communicates with the first channel 112 and the second channel 113 at the same time, and thus, the LED illuminator 120 disposed at the conductive point 117 can be electrically connected to the positive wire 115 in the first channel 112 and the negative wire 116 in the second channel 113 at the same time.

Specifically, the rubber insulating layer 111 includes a first cylindrical portion, a second cylindrical portion and a connecting portion 114 disposed between the first cylindrical portion and the second cylindrical portion. The first cylindrical portion is a circular tube-shaped member, and the first channel 112 is formed therein. The second cylindrical portion is a circular tube-shaped member, and the second channel 113 is formed therein.

Fig. 2 is a schematic structural diagram of the LED illuminator 120 in the LED lamp module 100 from a first viewing angle according to this example. With reference to Fig. 1 and Fig. 2, in this example, light emitting chips 128 are disposed in the LED illuminator 120, and the LED illuminator 120 emits light through the light emitting chips 128. The light emitting chips 128 are high-voltage chips. Therefore, even if the LED illuminators 120 in the LED lamp module 100 are connected to each other in parallel, the high-voltage product can be formed. When in use, the power supply demand can be met without using a transformer to convert commercial power into a low voltage below the safe voltage, thereby avoiding the problem of increased energy consumption caused by low conversion efficiency in the conversion process. It should be noted that the high-voltage chip is the prior art, and the invention does not attempt to propose a new high-voltage chip technology.

Further, there are a plurality of light emitting chips 128. The plurality of light emitting chips 128 are connected to each other in series, so that the required voltage of a single LED illuminator 120 can meet the requirement. Exemplarily, the number of the light emitting chips 128 is three. The three light emitting chips 128 are connected to each other in series, so the voltage is the sum of voltages of the three light emitting chips 128. It can be understood that in other examples, the number of the light emitting chips 128 may also be set according to the voltage of the required LED illuminator 120. For example, the number of the light emitting chips 128 is set as one, two or four, etc.

Further, the LED illuminator 120 further includes a current limiting IC 127. The current limiting IC 127 is connected to the light emitting chips 128 in series. The current limiting IC 127 is disposed to ensure that the current output by each LED illuminator 120 is kept the same. As long as the voltage between the head and tail of the LED lamp module 100 is within the working voltage range of the current limiting IC 127, the brightness of the LED illuminators 120 at the head and tail in the LED lamp module 100 can be kept the same.

Specifically, the LED illuminator 120 includes a bracket 121, and a first substrate 122 and a second substrate 123 disposed on the bracket 121. The current limiting IC 127 is disposed on the first substrate 122, and the light emitting chips 128 are all disposed on the second substrate 123.

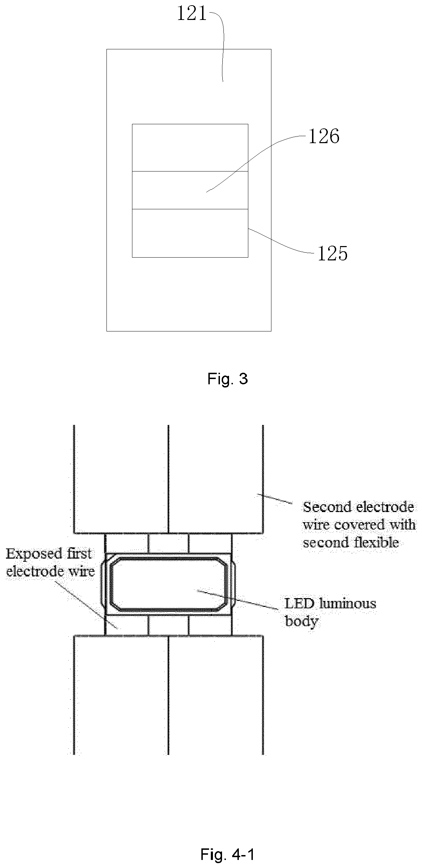

Fig. 3 is a schematic structural diagram of the LED illuminator 120 in the LED lamp module 100 from a second viewing angle according to this example. Specifically, Fig. 2 shows the structure of the front side of the LED illuminator 120, and Fig. 3 shows the structure of the back side of the LED illuminator 120. With reference to Fig. 1-Fig. 3, in this example, the LED illuminator 120 is a double-sided light-emitting illuminator, so that the light emitting range of the illuminator is larger, and the use effect is better.

Specifically, the bracket 121 of the LED illuminator 120 has a first cup 124 and a second cup 125 disposed back to back. A light transmitting layer 126 is disposed between the first cup 124 the second cup 125, so that light emitted from the first cup 124 can pass through the light transmitting layer 126 and exit from the second cup 125, or light emitted from the second cup 125 can pass through the light transmitting layer 126 and exit from the first cup 124.

Optionally, a part of the first substrate 122 and a part of the second substrate 123 respectively form a part of the bottom wall of the first cup 124. The light emitting chip 128 is disposed in the first cup 124, and fixed to the second substrate 123 by welding. The current limiting IC 127 is disposed in the first cup 124, and fixed to the first substrate 122 by welding. The light transmitting layer 126 is disposed between the first substrate 122 and the second substrate 123, that is, the light emitted from the first cup 124 by the light emitting chip 128 passes through the light transmitting layer 126, enters the second cup 125, and is emitted outward, thereby achieving the effect of double-sided light emission. Specifically, the light transmitting layer 126 is made of a material having certain light transmittance.

A diffusion layer is disposed in the second cup 125. The diffusion layer is made of a diffusing material. When the light entering the second cup 125 from the first cup 124 is emitted outward, the light is diffused through the diffusing material in the diffusion layer, so that there is no big difference between the light emitting effect of the back side and the light emitting effect of the front side of the LED illuminator 120, thereby improving the luminous efficiency of the LED illuminator 120.

Further, the two ends of the LED lamp module 100 are also provided with male and female connectors (not shown), which facilitates the connection of a plurality of LED lamp modules 100.

The working principle of the LED lamp module 100 according to this example is as follows:
During production, first, the combined blade is used to cut off the rubber insulating layer 111 of the outdoor rubber cord 110 to form the conductive point 117, and then the LED illuminator 120 is fixed to the positive wire 115 and the negative wire 116 exposed at the conductive point 117 by welding, so that the LED illuminator 120 is electrically connected to both the positive wire 115 and the negative wire 116. Then, the glue is applied to the LED illuminator 120, thereby forming the package 130 that completely wraps the LED illuminator 120 and the conductive point 117. When in use, the LED lamp module 100 is cut according to demands to obtain a lamp with a required number of LED illuminators, and then, the outdoor rubber cord 110 is used to supply power to the LED illuminators 120.

The LED lamp module 100 provided by this example at least has the following advantages:
The outdoor rubber cord is used in the LED lamp module 100 provided by the example of the invention, so the problem of aging during use can be effectively avoided, and the service life can be prolonged. The LED illuminator 120 is fixed to the conductive point 117 of the outdoor rubber cord 110 by welding, and the package 130 is disposed at the LED illuminator 120 and the conductive point 117 to wrap them, so that the LED illuminator 120 can be protected on the premise of ensuring the waterproof effect, thereby preventing the LED illuminator 120 from being damaged. The light emitting chips 128 in the LED illuminator 120 are high-voltage chips, so the LED lamp module 100 formed by parallel connection of the plurality of LED illuminators 120 is a high-voltage product. When in use, the LED lamp module can be cut freely according to demands. The current limiting IC 127 is disposed in the LED illuminator 120, thereby ensuring that the brightness of the LED illuminators 120 at the head and tail of the LED lamp module 100 can be kept the same.

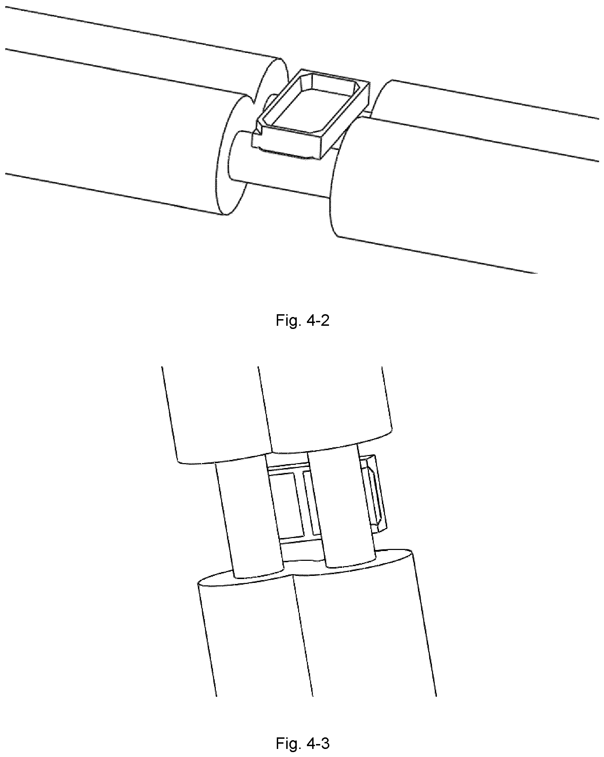

In another example, as shown in Fig. 4-1, Fig. 4-2 and Fig. 4-3, the exposed first electrode wire formed in the region cut by the blade, the second electrode wire covered with the second flexible insulating layer in the uncut region, and the LED illuminator are illustrated.

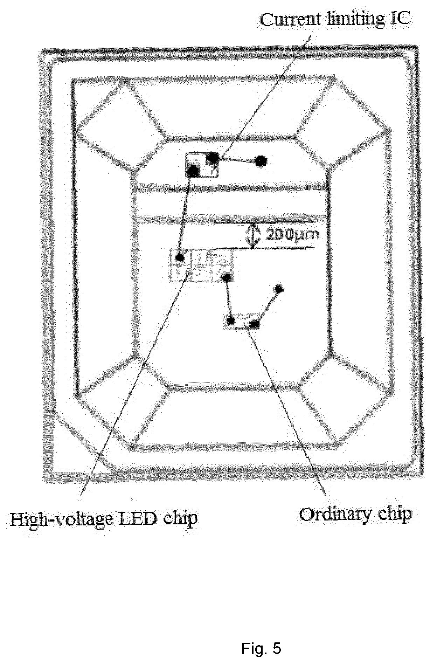

In another example, as shown in Fig. 5, the light emitting chips in the LED illuminator may also be a high-voltage chip and a non-high-voltage ordinary chip connected in series, and then the high-voltage chip is further connected to the current limiting IC. Besides, Fig. 5 exemplarily shows that there should be a spacing between the high-voltage chip and the electrode wire below to prevent improper conduction. The spacing shown in the figure is 200 micrometers. It can be understood that the inside of the LED illuminator may include one high-voltage chip, a plurality of high-voltage chips, a plurality of low-voltage chips, a combination of high-voltage and low-voltage chips or the like, which depends mainly on the magnitude of the voltage and the cost requirements.

In another example, as shown in Fig. 6-1 and Fig. 6-2, a front view after packaging with the glue and a side view after packaging are illustrated, and front glue and side glue are also illustrated. It should be noted that the black color of the front glue and side glue in the figures has no other restrictive meanings, and it is just used to highlight the front glue and the side glue, rather than indicating the glue after packaging is black. It can be understood that, in general, the glue after packaging is in a state having certain light transmittance, for example, being transparent, being translucent, having a certain hazy effect, etc.

The foregoing descriptions are merely specific implementations of the invention, but the protection scope of the invention is not limited thereto. Any variation or replacement readily figured out by those skilled in the art within the technical scope disclosed in the invention shall fall within the protection scope of the invention. Therefore, the protection scope of the invention shall be subject to the protection scope of the claims.

## Claims

1. An LED lamp module, comprising:
a first LED illuminator,
a first electrode wire covered with a first flexible insulating layer, and
a second electrode wire covered with a second flexible insulating layer,
wherein
two sides of the first LED illuminator at least comprise: a first wire pin corresponding to a first electrode wire and a second wire pin corresponding to a second electrode wire;
the first electrode wire continuously runs through the two sides of the first LED illuminator, and the first electrode wire is connected to a first conductive pin of the first LED illuminator; wherein the position connected to the first conductive pin is a first conductive point of the first electrode wire;
the second electrode wire continuously runs through the two sides of the first LED illuminator, and the second electrode wire is connected to a second conductive pin of the first LED illuminator; wherein the position connected to the second conductive pin is a second conductive point of the second electrode wire;
the first and second conductive points are connected to the first and second conductive pins, after the flexible insulating layer of the first electrode wire and the flexible insulating layer of the second electrode wire have been previously removed; and
among two ends of the first electrode wire and two ends of the second electrode wire, at least 2 terminals are left, wherein the 2 terminals are located on the same side, and are of the first electrode wire and of the second electrode wire respectively, and are used for forming a front or back cascade connection to another module of the same structure, or for connection to a power source.

2. The module according to claim 1, wherein preferably,
the first and second conductive pins, the first and second conductive points and the first LED illuminator are all packaged in a package having a certain light transmittance.

3. The module according to claim 1, wherein
the flexible insulating layer is made of a rubber material or a PVC material.

4. The module according to claim 1, wherein
the first electrode wire and the second electrode wire are connected via a first connecting portion having insulating properties.

5. The module according to claim 1, wherein
the first electrode wire and the second electrode wire are both covered by a third insulating layer.

6. The module according to claim 1, wherein
the first and second conductive points are formed by cutting the first and second electrode wires by a combined blade.

7. The module according to claim 1, wherein
when the connected power source is of an AC type, the first LED illuminator further comprises an AC/DC unit;
when the connected power source is of a DC or AC type, the first LED illuminator further comprises a current limiting IC.

8. The module according to claim 2, wherein
the package at least has any one of the following characteristics:
(1) the outside of the package is sleeved with a casing with a shape, or the outside of the package is modeled by injection molding;
(2) the package is packaged by glue;
(3) the package has a substantially spherical structure.

9. The module according to claim 2, wherein
the module at least has any one of the following characteristics:
(1) the first electrode wire further continuously runs through two sides of a second LED illuminator, and the first electrode wire is connected to a fifth conductive pin of the second LED illuminator; wherein the position connected to the fifth conductive pin is a fifth conductive point of the first electrode wire;
the first electrode wire further continuously runs through the two sides of the second LED illuminator, and the first electrode wire is connected to a sixth conductive pin of the second LED illuminator; wherein the position connected to the sixth conductive pin is a sixth conductive point of the first electrode wire;
the first and second LED illuminators are suitable to be cut apart, so as to facilitate a free cutting and use of the module; and
(2) the inside of the first LED illuminator at least comprises two LED chips connected in series to accurately control the current of the LED illuminator during voltage division.

10. An LED lamp, comprising:
an outside package structure having a certain light transmittance; wherein
the module according to any one of claims 1 to 9 is encapsulated in the outside package structure.
